# EUROPEAN PATENT APPLICATION

(11) **EP 4 322 211 A1**
(43) Date of publication of application: **14.02.2024**
(21) Application number: 22189556.8
(22) Date of filing: 09.08.2022
(51) Int. Cl.: H01L 23/427, H01L 25/075

(54) **THREE-DIMENSIONAL CHIP COMPRISING HEAT TRANSFER MEANS**

(71) Applicant: Nokia Technologies Oy, 02610 Espoo (FI)
(72) Inventor: YANG, Liu, Murray Hill, 07974 (US); AMALFI, Raffaele Luca, New Providence, 07974 (US); ENRIGHT, Ryan, Floral Park, 11001 (US)
(74) Representative: Swindell & Pearson Limited

(57) **Abstract**

Examples of the disclosure relate to a three-dimensional chip. The three-dimensional chip comprises a plurality of integrated circuit layers and one or more microfluidic channel layers. The plurality of integrated circuit layers comprises one or more electronic and/or photonic components and are arranged in a stack. The one or more microfluidic channel layers are positioned between integrated circuit layers. The microfluidic channel layers comprise microfluidic channels and the microfluidic channels are configured to enable working fluid to flow through the microfluidic channels to provide passive heat transfer means for the one or more electronic and/or photonic components in the integrated circuit layers. The microfluidic channels comprise one or more portions that extend along a microfluidic channel layer and one or more portions that extend through a microfluidic channel layer.

## Description

### TECHNOLOGICAL FIELD

Examples of the disclosure relate to a three-dimensional chip comprising heat transfer means. Some relate to a three-dimensional chip comprising passive heat transfer means.

### BACKGROUND

Chips such as three-dimensional chips comprise circuitry and electronic and/or photonic components that can generate unwanted heat during use. It is therefore useful for the chips to comprise heat transfer means to enable cooling of the components within the chips.

### BRIEF SUMMARY

According to various, but not necessarily all, examples of the disclosure there may be provided a three-dimensional chip comprising:
a plurality of integrated circuit layers wherein the plurality of integrated circuit layers comprises one or more electronic and/or photonic components and are arranged in a stack;
one or more microfluidic channel layers positioned between integrated circuit layers wherein the microfluidic channel layers comprise microfluidic channels and the microfluidic channels are configured to enable working fluid to flow through the microfluidic channels to provide passive heat transfer means for the one or more electronic and/or photonic components in the integrated circuit layers; and
wherein the microfluidic channels comprise one or more portions that extend along a microfluidic channel layer and one or more portions that extend through a microfluidic channel layer.

The passive heat transfer means may comprise a heat pipe.

The passive heat transfer means may comprise an oscillating heat pipe.

The passive heat transfer mean may comprise a two-phase cooling system.

The microfluidic channel layers may comprise one or more vias configured to enable electrical signals to be transferred between integrated circuit layers on either side of the microfluidic channel layer.

The microfluidic channel layers may comprise one or more of the vias are also configured to enable working fluid to flow between integrated circuit layers on either side of the microfluidic channel layer.

The three-dimensional chip may comprise a heat rejection surface.

The microfluidic channels may be configured to enable heat transfer from the integrated chip layers, though the three-dimensional chip to the heat rejection surface.

The heat rejection surface may be configured to be cooled by an active cooling system.

The three-dimensional chip may comprise means for connecting the three-dimensional chip to a circuit board.

According to various, but not necessarily all, examples of the disclosure there may be provided a method comprising:
forming two or more integrated circuit layers wherein the integrated circuit layers comprise one or more electronic and/or photonic components;
forming one or more microfluidic channel layers wherein the microfluidic channel layers comprise microfluidic channels are configured to enable working fluid to flow through the microfluidic channels to provide passive heat transfer means for the one or more electronic and/or photonic components in the integrated circuit layers and the microfluidic channels comprise one or more portions that extend along the microfluidic channel layer and one or more portions that extend through the microfluidic channel layer; and
forming a three-dimensional chip by stacking alternating layers of integrated circuit layers and microfluidic channel layers.

The method may comprise bonding the alternating layers of integrated circuit layers and microfluidic channel layers together.

The microfluidic channel layers may be formed by etching microfluidic channels into a substrate.

The method may comprise sealing the chip in a metallization layer.

### BRIEF DESCRIPTION

Some examples will now be described with reference to the accompanying drawings in which:
FIG. 1 shows a three-dimensional chip;
FIG. 2 shows a three-dimensional chip;
FIG. 3 shows an oscillating heat pipe;
FIGS. 4A to 4E show a three-dimensional chip;
FIGS. 5A to 5E show a three-dimensional chip;
FIGS. 6A to 6E show a three-dimensional chip;
FIGS. 7A to 7E show a three-dimensional chip;
FIG. 8 shows an example method;
FIGS. 9A to 9F show a method for forming an integrated circuit layer;
FIGS. 10A to 10G show a method for forming a microfluidic channel layer;
FIGS. 11A to 22G show a method for assembling a three-dimensional chip;
FIGS. 12A to 121 show a method for forming vias in a substrate;
FIGS. 13A to 13E how another method for assembling a three-dimensional chip; and
FIGS. 14A to 14D show three-dimensional chips.

### DETAILED DESCRIPTION

Examples of the disclosure relate to a three-dimensional chip comprising heat transfer means. The three-dimensional chip can comprise a three-dimensional integrated circuit. The three-dimensional chip can comprise two or more two dimensional integrated circuits stacked on top of each other. The three-dimensional chip can operate as a single unit and requires a smaller footprint compared to a corresponding two-dimensional integrated circuit or chip. However, stacking the two-dimensional integrated circuits on top of each other can result in overheating of components within the integrated circuits. Examples of the disclosure therefore provide heat transfer means within the three-dimensional chip so as to enable cooling of components within the integrated circuit.

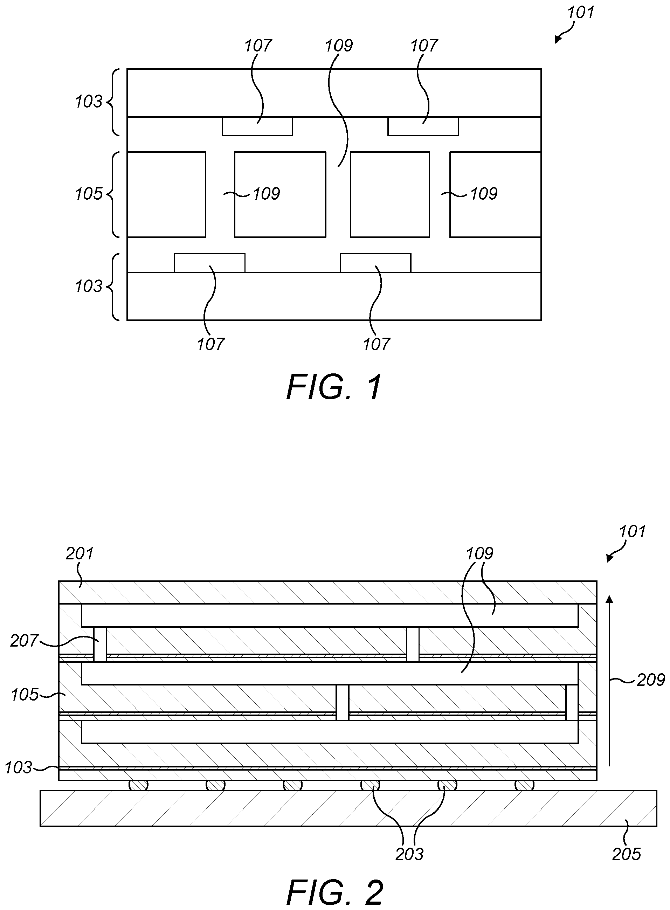

Fig. 1 schematically shows a cross section through part of a three-dimensional chip 101 according to examples of the disclosure. In the example of Fig. 1 the three-dimensional chip 101 comprises integrated circuit layers 103 and microfluidic channel layers 105. Only components referred to in the following description are shown in Fig. 1. The three-dimensional chip 101 could comprise other components in examples of the disclosure.

The three-dimensional chip 101 can comprise a plurality of integrated circuit layers 103. In the example of Fig. 1 the three-dimensional chip 101 comprises two integrated circuit layers 103. The three-dimensional chip 101 can comprise more than two integrated circuit layers 103 in other examples.

The respective integrated circuit layers 103 can comprise one or more electronic and/or photonic components 107. In the example of Fig. 1 the components 107 are shown as discrete components. In some examples the components 107 can be integrated for instance the components 107 could comprise integrated circuits, photonic circuits, III-V semiconductor chips, II-VI semiconductor-chips, MEMS (Micro-electromechanical system) semi-conductor chips or any suitable type of semiconductor chips. The components 107 can be integrated into a heterogeneous integrated systems using a stacking method. The components 107 can comprise active components such as transistors, photo diodes, lasers, and/or passive components such as inductors, capacitors, resistors, wave guides, wirings, or any other suitable type of components 107.

The components 107 can protrude from the surface of the integrated circuit layers 103, be embedded in the integrated circuit layers 103 or be flush to surface of the integrated circuit layers 103. The components 107 can comprise components such as memories, processors or any other suitable components. The components 107 can comprise high power components and/or low power components. The electronic components 107 can generate unwanted heat during use.

In the example of Fig. 1 two electronic and/or photonic components 107 are shown on each of the integrated circuit layers 103. Other numbers of electronic and/or photonic components 107 can be used in other examples of the disclosure. The respective integrated circuit layers 103 can comprise electrical connections connecting two or more electronic and/or photonic components 107. In some examples the three-dimensional chip 101 can comprise connections that extend between layers. Such connections can enable a component 107 on a first integrated circuit layer 103 to be connected to a component 107 on a second integrated circuit layer 103. Such connections could extend through one or more layers within the three-dimensional chip 101. For instance, in some examples one or more vias could be provided where the vias extend through a microfluidic channel layer 105 and/or an integrated circuit layer 103.

The integrated circuit layers 103 are arranged in a stack. The integrated circuit layers 103 are arranged in a stack so that a first integrated circuit layer 103 at least partially overlays a second integrated circuit layer 103. In some examples the first integrated circuit layer 103 can overlay the second integrated circuit layer 103 so that it is positioned within the footprint of the second integrated circuit layer 103. One or more intervening layers can be provided between respective integrated circuit layers 103 within the stack. The intervening layers could be microfluidic channel layers 105 as shown in Fig. 1 and/or any other suitable type of layer.

The microfluidic channel layer 105 is positioned between the integrated circuit layers 103. The microfluidic channel layers 105 comprise microfluidic channels 109. The microfluidic channels 109 can be etched within a substrate or formed using any other suitable means. The substrate could be a thermally insulating substrate. The substrate could comprise silicon or any other suitable type of material.

The microfluidic channels 109 are configured to enable working fluid to flow through the microfluidic channels 109 so as to provide passive heat transfer means for the one or more electronic components 107 in the integrated circuit layers 103.

The microfluidic channels 109 can comprise one or more portions that extend along a microfluidic channel layer 105. For example, they could extend parallel to, or substantially parallel to, the surface of the substrate from which the microfluidic channel layer 105 has been formed. For instance, the microfluidic channels 109 could extend into the page as shown in Fig. 1.

The microfluidic channels 109 can comprise one or more portions that extend through a microfluidic channel layer 105. For example, they could extend perpendicular to, or substantially perpendicular to, the surface of the substrate from which the microfluidic channel layer 105 has been formed. Examples of microfluidic channels 109 that extend through a microfluidic channel layer 105 are shown in Fig. 1. The microfluidic channels 109 extend right though the microfluidic channel layer 105 so that working fluid can move through the stack of layers.

The passive heat transfer means provided by working fluid moving through the microfluidic channels 109 can comprises a heat pipe such as an oscillating heat pipe and/or can comprise any other suitable type of heat transfer means. The heat transfer means can be passive in that no external pump is needed to move the working fluid through the microfluidic channels. The passive heat transfer means can comprise a two-phase cooling system and/or any other suitable means.

The schematic example of Fig. 1 shows two integrated circuit layers 103 with a single microfluidic channel layer 105 positioned between them. Other arrangements for the layers within a stack could be used in other examples of the disclosure. For instance, the three-dimensional chip 101 can comprise more than two integrated circuit layers 103 and a microfluidic channel layer 105 can be positioned between respective pairs of the integrated circuit layers 103. In some examples more than one microfluidic channel layer 105 could be positioned between the respective integrated circuit layers 103.

Fig. 2 schematically shows another three-dimensional chip 101 according to examples of the disclosure. The three-dimensional chip 101 comprises a plurality of integrated circuit layers 103 and a plurality of microfluidic channel layers 105. The integrated circuit layers 103 and the microfluidic channel layers 105 can be as shown in Fig. 1 and corresponding reference numerals can be used for corresponding features. In the example of Fig. 2 the three-dimensional chip 101 also comprises a heat rejection surface 201 and means 203 for connecting the three-dimensional chip 101 to a substrate 205.

Three integrated circuit layers 103 are shown in Fig. 2. The integrated circuit layers 103 are shown as thick lines in Fig. 2. The electronic components 107 are not shown in Fig. 2 but could be provided in any suitable locations on the integrated circuit layers 103.

The microfluidic channel layers 105 are provided between the integrated circuit layers 103. In the example of Fig. 2 a microfluidic channel layer 105 is also provided between an integrated circuit layer 103 and the heat rejection surface 201. This can ensure good heat transfer to the heat rejection surface 201.

In the example of Fig. 2 the microfluidic channel layers 105 can comprise vias 207. The vias 207 can enable working fluid to be transferred from one microfluidic channel layer 105 to another microfluidic channel layer 105. In the example of Fig. 2 the vias 207 extend through both the microfluidic layers 105 and the integrated circuit layers 103. The vias 207 extend in a direction that is parallel to, or substantially parallel to, the heat rejection surface 201.

In some examples the microfluidic channel layers 105 can comprise one or more vias configured to enable electrical signals to be transferred between integrated circuit layers 103 on either side of the microfluidic channel layer 105.

In some examples one or more vias can be configured to enable both working fluid and electronic signals to be transferred between respective integrated circuit layers 103. For instance, the vias could comprise a microfluidic channel with a conductive coating on the walls of the channel. The conductive coating could enable signals to be transferred between the different layers of the three-dimensional chip 101. The electronic signals that are transferred could comprise radio frequency signals or other suitable signals. In such examples the working fluid that is used for the heat transfer means could be selected to have dielectric properties that do not interfere with the transfer of the electrical signals.

The heat rejection surface 201 is provided on a first side of the three-dimensional chip 101. The heat rejection surface 201 can be provided on an opposing side of the three-dimensional chip 101 to the means for connecting the three-dimensional chip 101 to a circuit board.

The heat rejection surface 201 comprises a flat, or substantially flat, surface. A secondary heat transfer means can be configured to remove heat from the heat rejection surface 201. The secondary heat transfer means could be an active cooling system. The active cooling system could be pump driven whereas the passive cooling system provided by the microfluidic channels is not pump driven. The active cooling system could be an air-cooling system, a liquid cooling system, a two-phase cooling system or any other suitable type of cooling system. The secondary heat transfer means is not shown in Fig. 2.

The microfluidic channels 109 are configured to enable heat transfer from the integrated circuit layers 103, though the three-dimensional chip 101 to the heat rejection surface 201. The microfluidic channels are configured so that, at least some, of the working fluid in the microfluidic channels 109 flows in a direction towards the heat rejection surface 201. For example, the vias 207 are configured to transport working fluid in a direction towards the heat rejection surface 201. The vias 207 can be configured to enable heat to be transferred through the three dimensional-chip in the direction indicated by the arrow 209. The movement of the working fluid towards the heat rejection surface 201 is driven by an internal force such as capillary action within the microfluidic channels 109 rather than an external force such as a pump or other driving means.

The example three-dimensional chip 101 also comprises means 203 for connecting the three-dimensional chip 101 to a substrate 205. The substrate 205 could be a circuit board such as a printed circuit board (PCB) or any other suitable type of substrate. The means 203 for connecting the three-dimensional chip 101 to the substrate 205 can comprise solder deposits and/or solder pads or any other suitable means.

The means 203 for connecting the three-dimensional chip 101 can be located on an opposing surface of the three-dimensional chip 101 to the heat rejection surface 201.

The vias 207 in the microfluidic channels 109 can therefore be configured to transfer heat away from the substrate 205 towards the heat rejection surface 201.

The microfluidic channels 109 within the example three-dimensional chips can be arranged in any suitable arrangement. In some examples the microfluidic channels 109 can be arranged to provide an oscillating heat pipe.

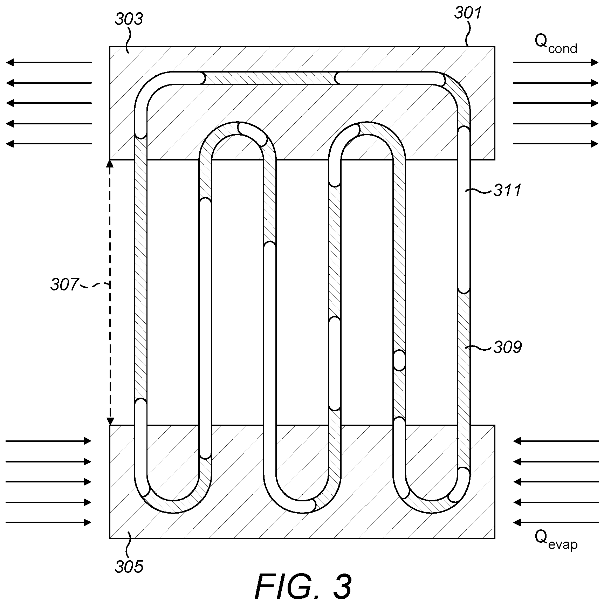

Fig. 3 shows an example oscillating heat pipe 301 that could be provided by the microfluidic channels 109 in some examples of the disclosure. The oscillating heat pipe 301 comprises a condenser region 303, an evaporator region 305 and an adiabatic section 307.

The evaporator region 305 comprises any means for transferring heat from a heat source into the working fluid within the oscillating heat pipe 301. The evaporator region 305 is thermally coupled to a heat source, such as an integrated circuit layer 103 or an electronic and/or photonic component 107 within an integrated circuit layer 103.

The condenser region 303 comprises any means for transferring heat out of the working fluid within the oscillating heat pipe 301. The condenser region 303 is thermally coupled to a heat sink or any other suitable type of means for transferring heat out of the working fluid. The heat sink could be the heat rejection surface 201 or any other suitable means.

The oscillating heat pipe 301 is configured in a meandering or serpentine configuration comprising a plurality of bends. A first plurality of bends is located in the evaporator region 305 and a second plurality of bends is located in the condenser region 303. The oscillating heat pipe 301 is shown in a cross-sectional configuration in Fig.3. In examples of the disclosure the oscillating heat pipe 301 can be configured to transfer heat through a three-dimensional chip by using one or more microfluidic channel layers 105 with a microfluidic channel 109 that extends parallel to, or substantially parallel to, the surface of the evaporator region 305 and/or condenser region 303 and one or more microfluidic vias that extend perpendicular to, or substantially perpendicular to, the surface of the evaporator region 305 and/or condenser region 303.

In the example shown in Fig. 3 three U-shaped bends are shown in the evaporator region 305 and two U-shaped bends are shown in the condenser region 303. Other configurations and numbers of bends could be used in other examples of the disclosure. For instance, in other examples the bends might not be U-shaped. The meandering or serpentine configuration is configured so that the working fluid within the oscillating heat pipe 301 is alternately heated in the evaporator region 305 and cooled in the condenser region 303 of the oscillating heat pipe 301.

In the example shown in Fig. 3 the oscillating heat pipe 301 forms a closed loop. Other types of oscillating heat pipe 301 could be used in other examples of the disclosure. For instance, the oscillating heat pipe 301 could be an open loop oscillating heat pipe configured without connecting ends in the condenser region 303.

In the example shown in Fig. 3 an adiabatic section 307 is provided between the evaporator region 305 and the condenser region 303. The adiabatic section 307 extends between the bends in the condenser region 303 and the bends in the evaporator region 305. The adiabatic section 307 ensures that heat that is transferred into the working fluid in the evaporator region 305 is retained within the oscillating heat pipe 301 until the working fluid reaches the condenser region 303. In some examples the oscillating heat pipe 301 does not comprise an adiabatic section 307. Whether or not the oscillating heat pipe 301 comprises an adiabatic section 307 can depend on the application and system geometry of the oscillating heat pipe 301 and any other suitable factors.

When the oscillating heat pipe 301 is in use, heat is applied to the working fluid in the bends within the evaporator region 305. This heat causes, at least some of, the working fluid to evaporate. This evaporation results in an increase of vapour pressure inside the oscillating heat pipe 301 which causes the growth of bubbles within the evaporator region 305. The growth of the bubbles and the increase in vapour pressure forces liquid slugs 309 of the working fluid towards the condenser region 303. The working fluid that is pushed to the condenser region 303 is then cooled by the condenser. This cooling reduces the vapour pressure within the working fluid and causes condensation of the bubbles and provides a restoring force that pushes the working fluid back towards the evaporator region 305. This process of alternate bubble growth and condensation causes oscillation of the working fluid within the oscillating heat pipe 301 and allows for an efficient heat transfer between the evaporator region 305 and the condenser region 303.

The example oscillating heat pipe 301 in Fig. 3 comprises a single loop with a single evaporator region 305. In some examples the oscillating heat pipe 301 could comprise a plurality of loops. The different loops could comprise different evaporator regions 305 and could be configured to dissipate heat from different components and/or different integrated circuit layers 103. Having the plurality of loops can provide for design flexibility within the oscillating heat pipe 301. This can enable the number of bends and the geometry of the heat pipe to be optimized, or substantially optimized, for dissipating heat from the different regions within the three-dimensional chip 101.

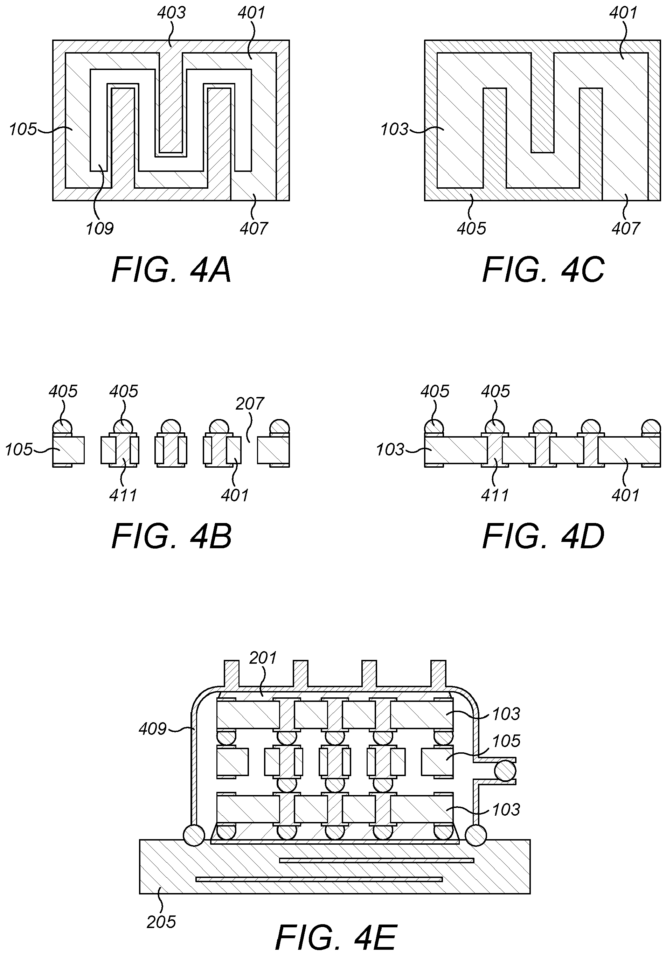

Figs. 4A to 4E show a three-dimensional chip 101 and components of an example three-dimensional chip 101.

Figs. 4A and 4B show an example microfluidic channel layer 105. Figs. 4C and 4D show an example integrated circuit layer 105 and Fig. 4E shows an example three-dimensional chip 101.

Fig. 4A shows a plan view of a microfluidic channel layer 105 and Fig. 4B shows a cross section through the microfluidic channel layer 105. The microfluidic channel layer 105 can be formed from a substrate 401. The substrate 401 can comprise silicon or any other suitable material.

The microfluidic channel layer 105 comprises a microfluidic channel 109. The microfluidic channel 109 can be etched into the substrate 401. In this example the microfluidic channel 109 extends along the substrate 401 in a serpentine shape. Other shapes and configurations could be used in other examples.

The microfluidic channel layer 105 also comprises a plurality of vias 207. The vias 207 can extend right through the substrate 401 to enable working fluid to flow from one side of the microfluidic channel layer 105 to the other. The vias 207 can therefore provide part of the microfluidic channels 109.

The microfluidic channel layer 105 as shown in Figs. 4A and 4B also comprises solder pads 403. The solder pads 403 can be comprise NiAu or any other suitable bonding material or adhesive. The solder pads 403 can comprise means for bonding the microfluidic channel layer 105 to other layers within the three-dimensional chip 101.

In the example of Fig. 4A the solder pad 403 can be formed around the edge of the microfluidic channel 109. A gap 407 is provided in the solder pad 403. The gap 407 can enable charging of the microfluidic channels 109 with working fluid.

In the example of Fig. 4B the substrate 401 also comprises a plurality of through substrate vias 411. The through substrate vias 411 can be formed by an electrically conductive material. The through substrate vias 411 can extend through the substrate 401 from one surface of the substrate 401 to an opposing surface of the substrate 401. The through substrate vias 411 can be formed from a conductive material such as copper, tungsten, conductive polymer, conductive solder or any other suitable type of material. The through substrate vias 411 can be configured to provide electrical connections between the different sides of the substrate 401.

The electrical vias 411 can be connected to solder bumps 405 on one side of the microfluidic channel layer 105 and the solder pad 403 on the other side of the microfluidic channel layer 105. The solder bumps 405 can be used to bond the microfluidic channel layer 105 to other layers within the three-dimensional chip 101. The solder bumps 405 can comprises dispensed or deposited dots or strips of adhesive material or solder material. The solder bumps 405 are shown as convex bumps in Figs. 4B but they could comprise bonding material of any suitable composition and shape in other examples.

In examples of the disclosure the solder pad 403 is dispensed or deposited on the substrate 401 so as to correspond with the position of the solder bumps 405. This can enable microfluidic channels 109 to be formed in the microfluidic channel layer 105.

Fig. 4C shows a plan view of an integrated circuit layer 103 and Fig. 4D shows a cross section though the integrated circuit layer 103. The integrated circuit layer 103 can also be formed from a substrate 401. The substrate 401 can comprise silicon or any other suitable material. One or more electronic and/or photonic components 107 can be mounted on the integrated circuit layer 103 or integrated in the integrated circuit layer 103. The electronic and/or photonic components 107 are not shown in Figs. 4C and 4D.

The integrated circuit layer 103 as shown in Figs. 4C and 4D also comprises means for bonding the integrated circuit layer 103 to other layers within the three-dimensional chip 101. In this example the means can be for bonding the integrated circuit layer 103 to a microfluidic channel layer 105 and/or any other suitable parts of the three-dimensional chip 103. In the example of Fig. 4C and 4D the means can comprise solder bumps 405 and solder pads 403. The plan view in Fig. 4C shows the solder deposit side of the integrated circuit layer 103. The solder pad can be provided on the other side of the integrated circuit layer 103. As shown in Fig. 4C a gap is provided in the solder bump 405. The gap can allow for charging of the microfluidic channels with working fluid.

The solder pads 403 and the solder bump 405 are provided around the edge of the integrated circuit layer 103 and in a pattern that corresponds to the pattern of the microfluidic channel 109.

In the example of Fig. 4D the substrate 401 also comprises a plurality of through substrate vias 411. The through substrate vias 411 can be as shown in Fig. 4B. The through substrate vias 411 can provide electrical connections for components on different sides of the substrate 401.

Fig. 4E shows an example three-dimensional chip 101. The three-dimensional chip 101 is formed from two integrated circuit layers 103 and a microfluidic channel positioned between the two integrated circuit layers 103. The respective layers 103, 105 are stacked on top of each other so that the upper layers are within the footprint of the lower layers.

One of the integrated circuit layers 103 is bonded to a substrate 205 and the other integrated circuit layer 103 is bonded to a heat rejection surface 201. The solder bumps 405 can be used to form walls to part of the three-dimensional chip 101.

The three-dimensional chip 101 can be encapsulated within an encapsulation layer 409. The encapsulation layer 409 can be made of any suitable material.

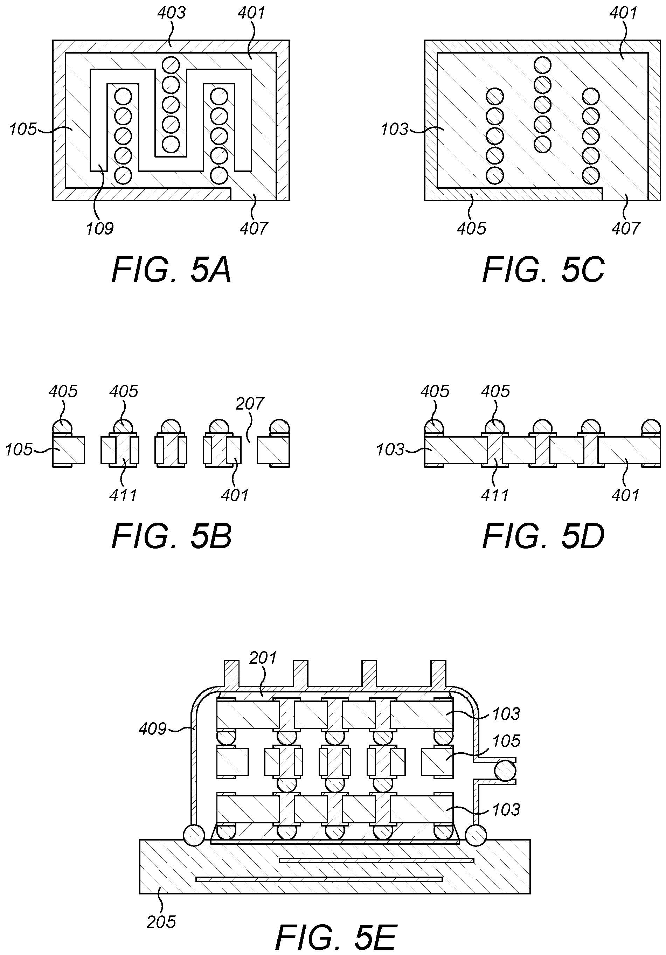

Figs. 5A to 5E show a three-dimensional chip101 and components of another example three-dimensional chip 101.

Figs. 5A and 5B show another example microfluidic channel layer 105. Fig. 5A shows a plan view of a microfluidic channel layer 105 and Fig. 5B shows a cross section through the microfluidic channel layer 105. Figs. 5C and 5D show an example integrated circuit layer 105. Fig. 5C shows a plan view of a microfluidic channel layer 105 and Fig. 5D shows a cross section through the microfluidic channel layer 105. Fig. 5E shows an example three-dimensional chip 101. The layers 105, 103 and three-dimensional chip 101 as shown in Figs. 5A to 5E are similar to those shown in Figs. 4A to 4E. Corresponding reference numerals are used for corresponding features.

The microfluidic channel layer 105 and the integrated circuit layer 103 as shown in Figs. 5A to 5D differ from that shown in Figs. 4A to 4D in that the solder pads 403 and solder bumps 405 are provided discontinuously in the interior of the microfluidic channel layer 105 and the integrated circuit layer 103. As shown in Fig. 5A there are gaps between sections of the solder pads 405 on the surface of the microfluidic channel layer 105. Similarly, there are gaps between sections of the solder bumps 405 in the surface of the integrated circuit layer 103. These gaps can enable respective sections of the solder pads 403 and solder bumps 405 to be electrically insulated from each other. This can enable these sections to be used to transmit electrical signals though the microfluidic channel layer 105 and/or the integrated circuit layer 103. For example, they could be used with vias to enable power and/or signals to be transferred between layers within the three-dimensional chip 101. The shape and arrangement of the solder bumps 405 still allows formation of microfluid channels 109 so that working fluid can flow through a low resistance path between columns of solder bump 405.

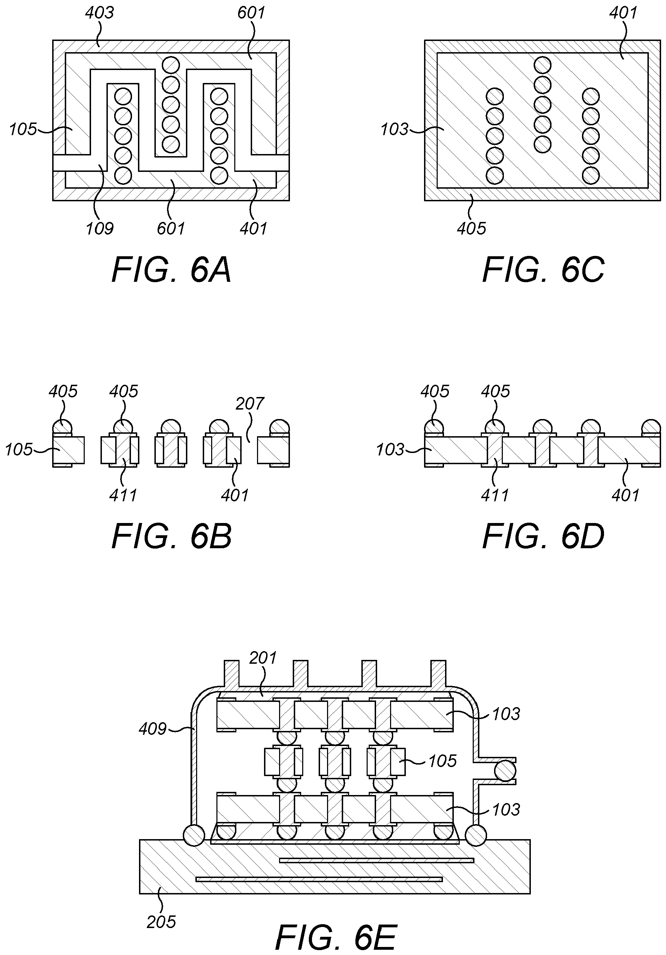

Figs. 6A to 6E show a three-dimensional chip101 and components of another example three-dimensional chip 101.

Figs. 6A and 6B show another example microfluidic channel layer 105. Fig. 6A shows a plan view of a microfluidic channel layer 105 and Fig. 6B shows a cross section through the microfluidic channel layer 105. Figs. 6C and 6D show an example integrated circuit layer 105. Fig. 6C shows a plan view of a microfluidic channel layer 105 and Fig. 6D shows a cross section through the microfluidic channel layer 105. Fig. 6E shows a cross section though an example three-dimensional chip 101. The layers 105, 103 and three-dimensional chip 101 as shown in Figs. 6A to 6E are similar to those shown in Figs. 4A to 5E. Corresponding reference numerals are used for corresponding features.

The microfluidic channel layer 105 as shown in Figs. 6A and 6B differ from the previous examples in that the microfluidic channel layer 105 can be formed from two or more discontinuous portions 601. In the example of Fig. 6A the microfluidic channel layer 105 is formed from two discontinuous portions 601. Other numbers of discontinuous portions 601 could be used in other examples of the disclosure.

The microfluidic channel 109 can be formed from gaps between the discontinuous portions 601. The discontinuous portions 601 can be bonded to integrated circuit layers 103 to form the three-dimensional chip 101 as shown in Fig. 6E. This bonding pairs corresponding discontinuous portions 601 together.

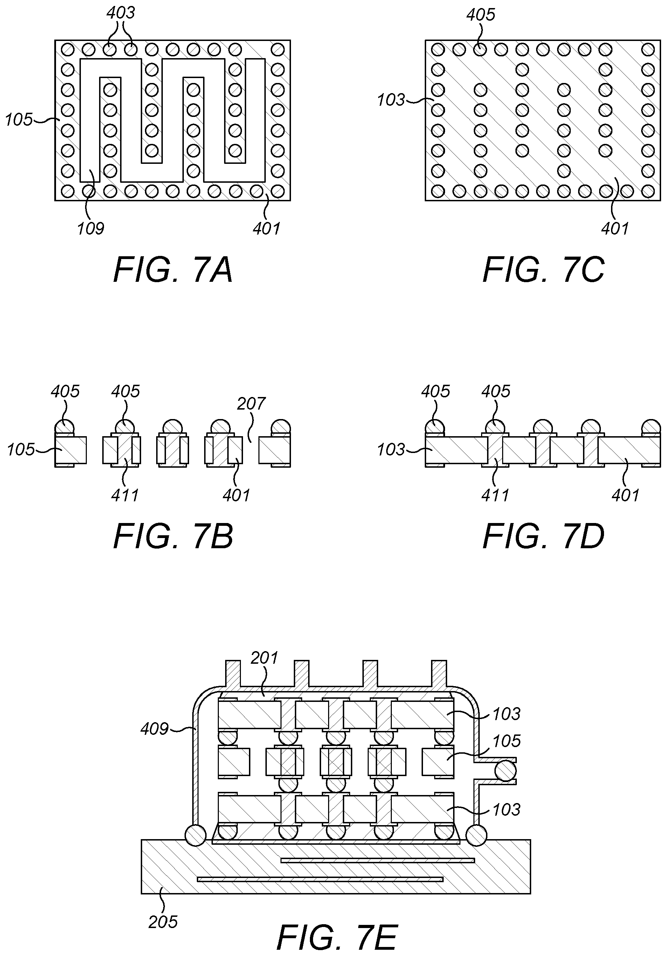

Figs. 7A to 7E show a three-dimensional chip101 and components of another example three-dimensional chip 101.

Figs. 7A and 7B show another example microfluidic channel layer 105. Fig. 7A shows a plan view of a microfluidic channel layer 105 and Fig. 7B shows a cross section through the microfluidic channel layer 105. Figs. 7C and 7D show an example integrated circuit layer 105. Fig. 7C shows a plan view of a microfluidic channel layer 105 and Fig. 7D shows a cross section through the microfluidic channel layer 105. Fig. 7E shows a cross section though an example three-dimensional chip 101. The layers 105, 103 and three-dimensional chip 101 as shown in Figs. 7A to 7E are similar to those shown in Figs. 4A to 6E. Corresponding reference numerals are used for corresponding features.

The microfluidic channel layer 105 and the integrated circuit layers 103 as shown in Figs. 7A to 7E differ from the previous examples in that the solder pads 403 and the solder bumps 405 are provided in discontinuous sections around the edges of the respective layers 103, 105. In this example there are gaps between sections of the solder pads 403 and the solder bumps 405 around the edges of the respective layers 103, 105. In this example the working fluid can be retained within the microfluidic channels 109 even without the continuous solder pads 403 and solder bumps 405 around the edges of the layers 103, 105. This may require working fluid with appropriate properties to be selected to prevent the working fluid from leaking through the gaps.

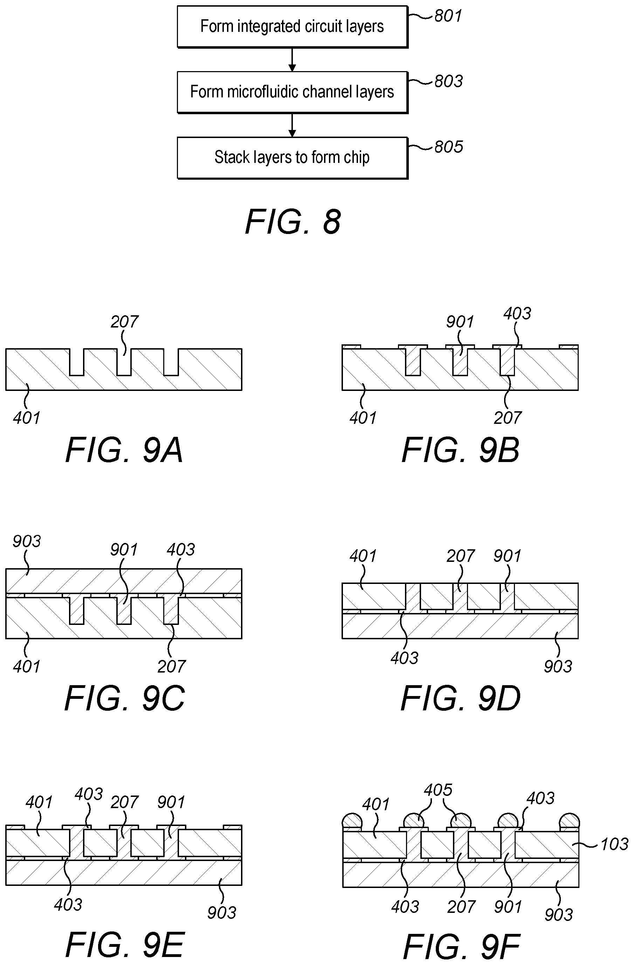

Fig. 8 shows an example method for fabricating a three-dimensional chip 101. The method could be used to fabricate a three-dimensional chip 101 such as the three-dimensional chips 101 and components of the three-dimensional chips 101 as shown in any of Figs. 1 to 7E.

The method comprises, at block 801, forming two or more integrated circuit layers 103. The integrated circuit layers 103 comprise one or more electronic and/or photonic components 107. The electronic and/or photonic components 107 can be mounted (or integrated) on a substrate 401. The substrate 401 could be formed from an insulating material such as and/or could comprise any other suitable material. The integrated circuit layer 103 can comprise any suitable circuits or circuitry. The integrated circuit layer 103 can comprise one or more components that generate unwanted heat during use.

Any suitable number of integrated circuit layers 103 can be formed in examples of the disclosure. To form a three-dimensional chip 101 two or more of the integrated circuit layers 103 can be used.

At block 803 the method comprises forming one or more microfluidic channel layers 105. The microfluidic channel layers 105 comprise microfluidic channels 109 that are configured to enable working fluid to flow through the microfluidic channels 109 to provide passive heat transfer means for the one or more electronic components in the integrated circuit layers 103. The microfluidic channels 109 comprise one or more portions that extend along the microfluidic channel layer 105 and one or more portions that extend through the microfluidic channel layer 103.

Any suitable means can be used to form the microfluidic channel layers 105. In some examples the microfluidic channel layers 105 can be formed by etching microfluidic channels 109 into a substrate 401. Any suitable etching processes can be used. The substate 401 can be formed from an insulating material such as silicon and/or can comprise any other suitable material.

At block 805 the method comprises forming a three-dimensional chip 101 by stacking alternating layers of integrated circuit layers 103 and microfluidic channel layers 105. The integrated circuit layers 103 and the microfluidic channel layers 105 can be bonded together using any suitable means.

Any suitable number of integrated circuit layers 103 and microfluidic channel layers 105 can be used to form the three-dimensional chip 101. For example, two integrated circuit layers 103 could be stacked with a microfluidic channel layer 105 between the two integrated circuit layers 103. Other numbers of layers 103, 105 and arrangements of the layers 103, 105 could be used in other examples of the disclosure.

Once the microfluidic layers 105 and the integrated circuit layers 103 have been stacked to gather to form a three-dimensional chip 101 the three-dimensional chip 101 can be sealed. In some examples the three-dimensional chip 101 can be sealed in a metallization layer. Other types of sealing means could be used in other examples of the disclosure.

Figs. 9A to 9F show a method for forming an integrated circuit layer 103. The integrated circuit layer 103 could be as shown in any of the examples of Fig. 1 to Fig. 7E. The method of Figs. 9A to 9F could be modified to provide different examples of integrated circuit layers 103.

In Fig. 9A vias 207 are formed in a substrate 401. The substrate 401 can be a silicon substrate or any other suitable type of substrate. The vias 207 can be formed using an etching process and/or any other suitable type of process. The forming of the vias 207 can be followed by an insulation process if appropriate. In Fig. 9A the vias 207 only extend part way through the substrate 401. Three vias 207 are shown in Fig. 9A. Other numbers of vias 207 could be formed in other examples.

In Fig. 9B the vias 207 are filled with a conductive material 901. The conductive material 901 could be copper and/or any other suitable material. The conductive material 901 fills the vias 207 and forms a contact pad 403 on the surface of the substrate 401. Any suitable process can be used to add the conductive material 901 to the vias 207.

In Fig. 9C the substrate 401 is bonded to a carrier substrate 903. The substrate 401 can be bonded to a carrier substrate 903 by a temporary bonding method such as adhesive bonding. This adhesive and the carrier substrate 903 will be removed during the fabrication of the three-dimensional chip 101 so as to expose the front side metal pads and enabling stacking of the respective layers 103, 105 during an assembly process.

In Fig. 9D the substrate 401 is thinned. The thinning of the substrate 401 can comprise chemical thinning, mechanical thinning, reactive ion etch or any other suitable process. The substrate 401 can be thinned so that the vias 207 that have been formed extend all of the way through the thinned substrate 401.

In Fig. 9E contact pads 403 are formed on the other side of the substrate 401 to the side that is bonded to the carrier substrate 903. The contact pads 403 can be formed from copper or any other suitable material or combination of material. The contact pads 403 can be deposited on the surface of the substrate 401 using any suitable process. In some examples, before the contact pads 403 are formed, the substrate 401 can be insulated with passivation. The contacts to the vias 207 can be reopened to enable electrical connections to the vias 207.

In Fig. 9F solder bumps 405 are formed on the contact pads 403 The solder bumps 405 can be formed from copper or any other suitable material or combination of material. The solder bumps 405 can be deposited on the contact pads 403 using any suitable process. The solder bumps 405 enable the integrated circuit layer 103 to be bonded to other layers within the three-dimensional chip 101.

One or more electronic and/or photonic components 107 can also be mounted (and/or integrated) onto the substrate 401. These are not shown in Figs. 9A to 9E.

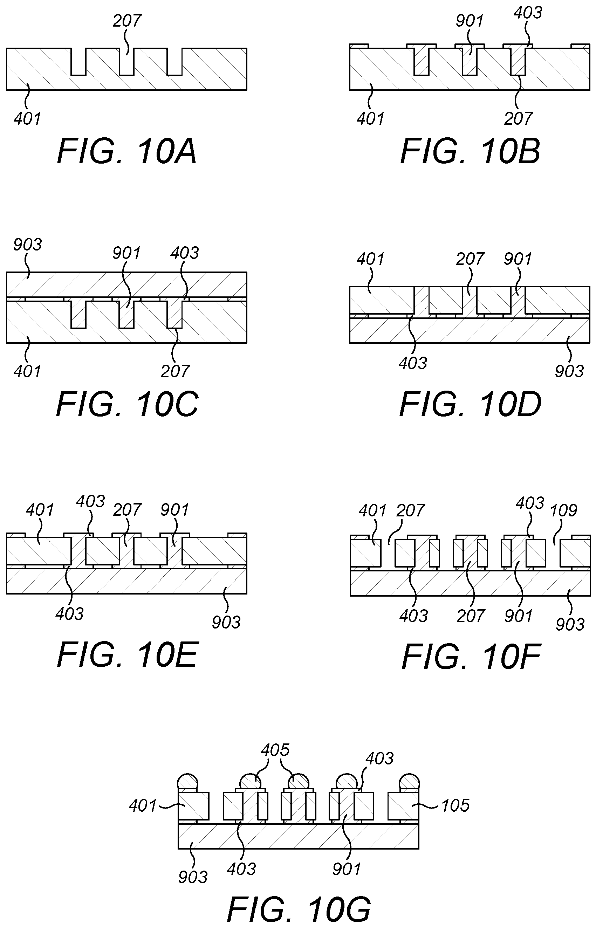

Figs. 10A to 10G show a method for forming a microfluidic channel layer 105. The microfluidic channel layer 105 could be as shown in any of the examples of Fig. 1 to Fig. 7E. The method of Figs. 10A to 10G could be modified to provide different examples of microfluidic channel layers 105.

In Fig. 10A vias 207 are formed in a substrate 401. The substrate 401 can be a silicon substrate or any other suitable type of substrate. The vias 207 can be formed using an etching process and/or any other suitable type of process. The forming of the vias 207 can be followed by an insulation process if appropriate. In Fig. 10A the vias 207 only extend part way through the substrate 401. Three vias 207 are shown in Fig. 10A. Other numbers of vias 207 could be formed in other examples.

In Fig. 10B the vias 207 are filled with a conductive material 901. The conductive material 901 could be copper and/or any other suitable material. The conductive material 901 fills the vias 207 and forms a contact pad 403 on the surface of the substrate 401. Any suitable process can be used to add the conductive material 901 to the vias 207. In some examples, before the contact pads 403 are formed, the substrate 401 can be insulated with passivation. The contacts to the vias 207 can be reopened to enable electrical connections to the vias 207.

In Fig. 10C the substrate 401 is bonded to a carrier substrate 903. The contact pads 403 can be used to bond the substrate 401 to the carrier substrate 903.

In Fig. 10D the substrate 401 is thinned. The thinning of the substrate 401 can comprise chemical thinning, mechanical thinning, reactive ion etch or any other suitable process. The substrate 401 can be thinned so that the vias 207 that have been formed extend all of the way through the thinned substrate 401.

In Fig. 10E contact pads 403 are formed on the other side of the substrate 401 to the side that is bonded to the carrier substrate 903. The contact pads 403 can be formed from copper or any other suitable material or combination of material. The contact pads 403 can be deposited on the surface of the substrate 401 using any suitable process.

In Fig. 10F the microfluidic channels 109 are formed in the substrate 401. The microfluidic channels 109 can comprise one or more vias 207 for the working fluid. The microfluidic channels 109 can be formed using an etching process and/or any other suitable type of process. The microfluidic channels 109 can be formed in any suitable configuration.

In Fig. 10G solder bumps 405 are formed on the contact pads 403 The solder bumps 405 can be formed from copper or any other suitable material or combination of material. The solder bumps 405 can be deposited on the contact pads 403 using any suitable process. The solder bumps 405 enable the microfluidic channel layer 105 to be bonded to other layers within the three-dimensional chip 101.

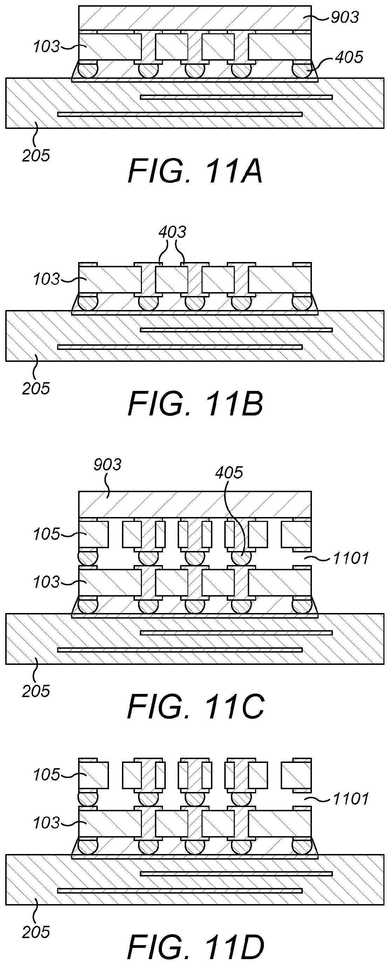

Figs. 11A to 11G show a method for assembling a three-dimensional chip 101. The three-dimensional chip 101could be as shown in any of the examples of Fig. 1 to Fig. 7E. The method of Figs. 11A to 11G could be modified to provide different examples of three-dimensional chips 101.

In Fig. 11A an integrated circuit layer 103 is bonded to a substrate 205. The solder bumps 405 can be used to bond the integrated circuit layer 103 to the substrate 205. Any space between the substrate 401 of the integrated circuit layer 103 and the substrate 205 can be filled. Any suitable material and process can be used to fill the space between the substrate 401 of the integrated circuit layer 103 and the substrate 205.

In Fig. 11B the carrier substrate 903 is removed from the integrated circuit layer 103. This leaves the contact pads 403 of the integrated circuit layer 103 exposed.

In Fig. 11C a microfluidic channel layer 105 is bonded to the integrated circuit layer 103. The solder bumps 405 on the microfluidic channel layer 105 can be used to bond the microfluidic channel layer 105 to the integrated circuit layer 103. The microfluidic channel layer 105 is bonded to the integrated circuit layer 103 so that the microfluidic channel layer 105 overlays the integrated circuit layer 103. The footprint of the microfluidic channel layer 105 is provided within the footprint of the integrated circuit layer 103.

In the example of Fig. 11C a gap 1101 is provided at an edge of the stack between the microfluidic channel layer 109 and the integrated circuit layer 103. The gap 1101 can enable the microfluidic channels 109 to be charged with working fluid. The gap 1101 can be formed from a gap in the solder bump 405 around the edge of the microfluidic channel layer 105.

In Fig. 11D the carrier substrate 903 is removed from the microfluidic channel layer 105. This leaves the contact pads 403 of the microfluidic channel layer 105 exposed.

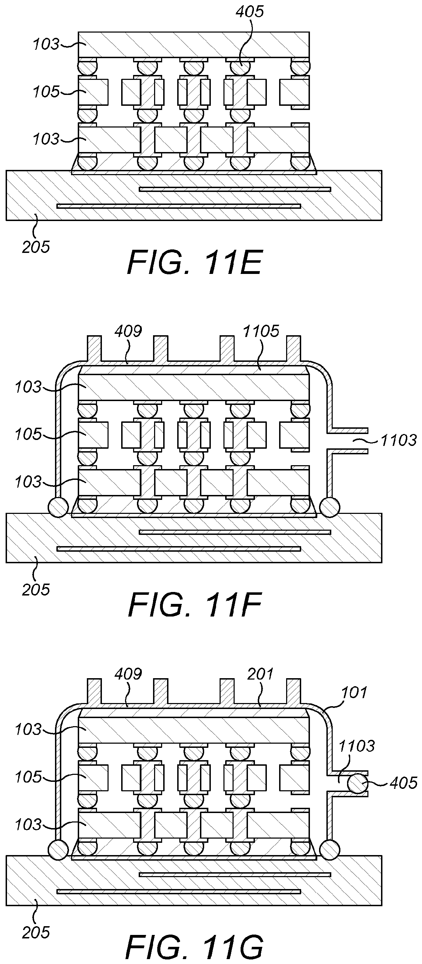

In Fig. 11E a second integrated circuit layer 103 is bonded to the microfluidic channel layer 105. The solder bumps 405 of the integrated circuit layer 103 can be used to bond the integrated circuit layer 103 to the contact pads 403 of the microfluidic channel layer 105. The second integrated circuit layer 103 is bonded to the microfluidic channel layer 105 so that the second integrated circuit layer 103 overlays the microfluidic channel layer 105 and the first integrated circuit layer 103. The footprint of the second integrated circuit layer 103 is provided within the footprint of the first integrated circuit layer 103.

In Fig. 11F a thermal interface material 1105 is attached to the top of the stack of layers 103, 105. The thermal interface material 1105 can be configured to enable effective heat transfer from the microfluidic channels 109 to a heat rejection surface 201. The thermal interface material 1105 can be bonded to a substrate 401 of an integrated circuit layer 103. Other means for attaching the thermal interface material 1105 to the stack of layers 103, 105 could be used in other examples.

Also, in Fig. 11F the stack of layers 103, 103, is housed within an encapsulation layer 409. The encapsulation layer 409 can be formed from metal or any other suitable material. The encapsulation layer 409 encapsulates the stack of layers 103, 103. In the example of Fig. 11F the encapsulation layer 409 comprises an inlet 1103. The inlet 1103 comprises a conduit within one of the walls of the encapsulation layer 409. The inlet 1103 can be aligned with the gap 1101 at the edge of the stack.

In Fig. 11G the three-dimensional chip 101 is completed by charging the microfluidic channels 109 of the microfluidic layer 105 with working fluid. The working fluid can be fed into the microfluidic channels 109 of the microfluidic layer 105 through the inlet 1103 of the encapsulation layer 409. Once the microfluidic channels 109 of the microfluidic layer 105 are charged with working fluid the inlet 1103 can be sealed. In the example of Fig. 11G the inlet 1103 can be sealed with a solder bump 405. Other means for sealing the inlet 1103 could be used in other examples.

In the example of Fig. 11 the three-dimensional chip 101 comprises two integrated circuit layers 103 positioned either side of a microfluidic channel layer 105. Other arrangements of the layer 103, 105 could be used in other examples of the disclosure.

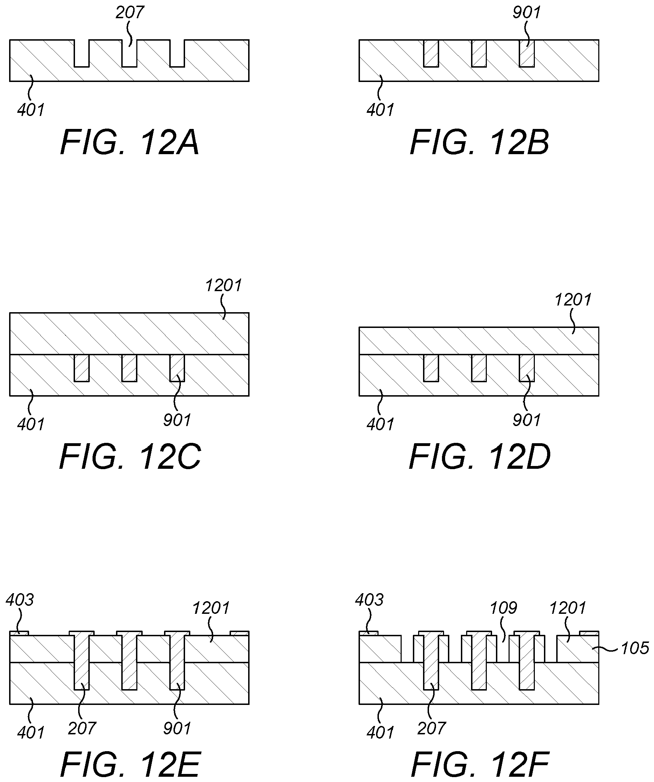

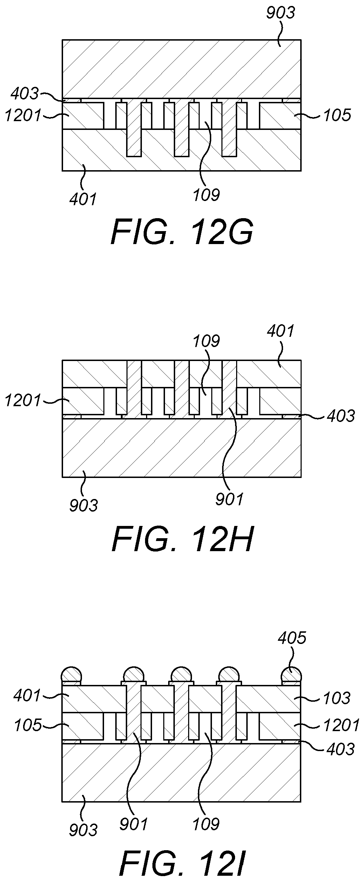

Figs. 12A to 121 show another method for forming a microfluidic channel layer 105 bonded to an integrated circuit layer 103. The microfluidic channel layer 105 and the integrated circuit layer 103 could be as shown in any of the examples of Fig. 1 to Fig. 7E. The method of Figs. 12A to 12G could be modified to provide different examples of microfluidic channel layers 105 and integrated circuit layers 103.

In Fig. 12A vias 207 are formed in a substrate 401. The substrate 401 can be a silicon substrate or any other suitable type of substrate. The vias 207 can be formed using an etching process and/or any other suitable type of process. In Fig. 12A the vias 207 only extend part way through the substrate 401. Three vias 207 are shown in Fig. 12A. Other numbers of vias 207 could be formed in other examples.

In Fig. 12B the vias 207 are filled with a conductive material 901. The conductive material 901 could be copper and/or any other suitable material. The conductive material 901 fills the vias 207. No contact pad is formed on the surface of the substrate 401 in this example. Any suitable process can be used to add the conductive material 901 to the vias 207.

In Fig. 12C the substrate 401 is bonded to another substrate 1201. The another substrate1201 can be formed from silicon or any other suitable material. The substrate 401 can be bonded to the another substrate 1201 using hybrid bonding or any other suitable means.

In Fig. 12D the another substrate 1201 is thinned. The thinning of the another substrate 1201 can comprise chemical thinning, mechanical thinning or any other suitable process.

In Fig. 12E vias 207 are formed through the another substrate 1201. The vias 207 formed through the another substrate 1201 are aligned with the vias 207 formed through the substrate 401. The vias 207 are filled with a conductive material 901. The vias can be configured to enable the transfer of electrical signals and/or power. Contact pads 403 are also formed on the surface of the another substrate 1201.

In Fig. 12F the microfluidic channels 109 are formed in the another substrate 1201. The microfluidic channels 109 can comprise one or more vias 207 for the working fluid. The microfluidic channels 109 can be formed using an etching process and/or any other suitable type of process. The microfluidic channels 109 can be formed in any suitable configuration. This forms a microfluidic channel layer in the another substrate 1201

In Fig. 12G the substrate 401 is bonded to a carrier substrate 903. The substrate 401 can be bonded to a carrier substrate 903 by a temporary bonding method such as adhesive bonding. This adhesive and the carrier substrate 903 will be removed during the fabrication of the three-dimensional chip 101 so as to expose the front side metal pads and enabling stacking of the respective layers 103, 105 during an assembly process.

In Fig. 12H the substrate 401 is thinned. The thinning of the substrate 401 can comprise chemical thinning, mechanical thinning or any other suitable process. The substrate 401 can be thinned so that the vias 207 that have been formed extend all of the way through the thinned substrate 401.

In Fig. 121 solder bumps 405 are formed on the contact pads 403 The solder bumps 405 can be formed from copper or any other suitable material or combination of material. The solder bumps 405 can be deposited on the contact pads 403 using any suitable process. This forms an integrated circuit layer 103 bonded to the microfluidic channel layer 105. One or more electronic components can also be provided on the surface of the substrate 401.

The solder bumps 405 enable the integrated circuit layer 103 to be bonded to other layers within the three-dimensional chip 101.

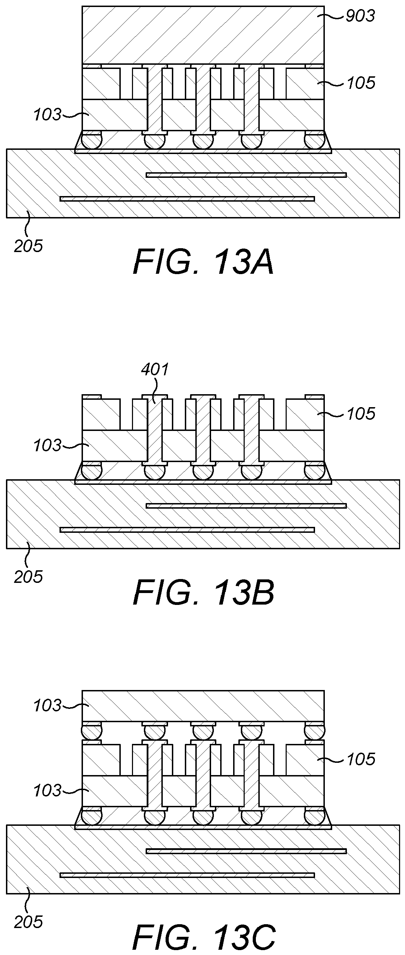

Figs. 13A to 13E show another method for assembling a three-dimensional chip 101. The three-dimensional chip 101 could be as shown in any of the examples of Fig. 1 to Fig. 7E. The method of Figs. 13A to 13E uses a a microfluidic channel layer 105 bonded to an integrated circuit layer 103 which could be formed using the method of Figs. 12A to 121 or any other suitable method.

In Fig. 13A the integrated circuit layer 103 is bonded to a substrate 205. The solder bumps 405 can be used to bond the integrated circuit layer 103 to the substrate 205. Any space between the substrate 401 of the integrated circuit layer 103 and the substrate 205 can be filled. Any suitable material and process can be used to fill the space between the substrate 401 of the integrated circuit layer 103 and the substrate 205.

In Fig. 13B the carrier substrate 903 is removed. This leaves the contact pads 403 of the microfluidic channel layer 105 that is bonded to the integrated circuit layer 103 exposed.

In Fig. 13C a second integrated circuit layer 103 is bonded to the microfluidic channel layer 105. The solder bumps 405 of the integrated circuit layer 103 can be used to bond the integrated circuit layer 103 to the contact pads 403 of the microfluidic channel layer 105. The second integrated circuit layer 103 is bonded to the microfluidic channel layer 105 so that the second integrated circuit layer 103 overlays the microfluidic channel layer 105 and the first integrated circuit layer 103. The footprint of the second integrated circuit layer 103 is provided within the footprint of the first integrated circuit layer 103.

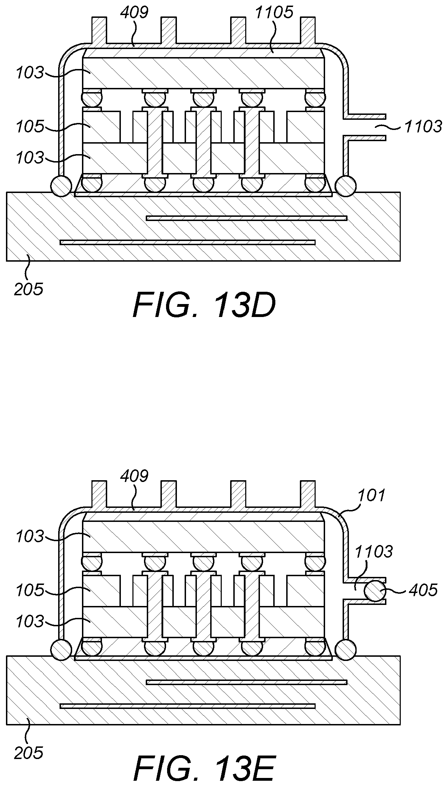

In Fig. 13D a thermal interface material 1105 is attached to the top of the stack of layers 103, 105. The thermal interface material 1105 can be configured to enable effective heat transfer from the microfluidic channels 109 to a heat rejection surface 201. The thermal interface material 1105 can be bonded to a substrate 401 of an integrated circuit layer 103. Other means for attaching the thermal interface material 1105 to the stack of layers 103, 105 could be used in other examples.

Also, in Fig. 13D the stack of layers 103, 103, is housed within an encapsulation layer 409. The encapsulation layer 409 can be formed from metal or any other suitable material. The encapsulation layer 409 encapsulates the stack of layers 103, 103. In the example of Fig. 13D the encapsulation layer 409 comprises an inlet 1103. The inlet 1103 comprises a conduit within one of the walls of the encapsulation layer 409.

In Fig. 13E the three-dimensional chip 101 is completed by charging the microfluidic channels 109 of the microfluidic layer 105 with working fluid. The working fluid can be fed into the microfluidic channels 109 of the microfluidic layer 105 through the inlet 1103 of the encapsulation layer 409. Once the microfluidic channels 109 of the microfluidic layer 105 are charged with working fluid the inlet 1103 can be sealed. In the example of Fig. 13E the inlet 1103 can be sealed with a solder bump 405. Other means for sealing the inlet 1103 could be used in other examples.

In the example of Fig. 13E the three-dimensional chip 101 comprises two integrated circuit layers 103 positioned either side of a microfluidic channel layer 105. Other arrangements of the layer 103, 105 could be used in other examples of the disclosure.

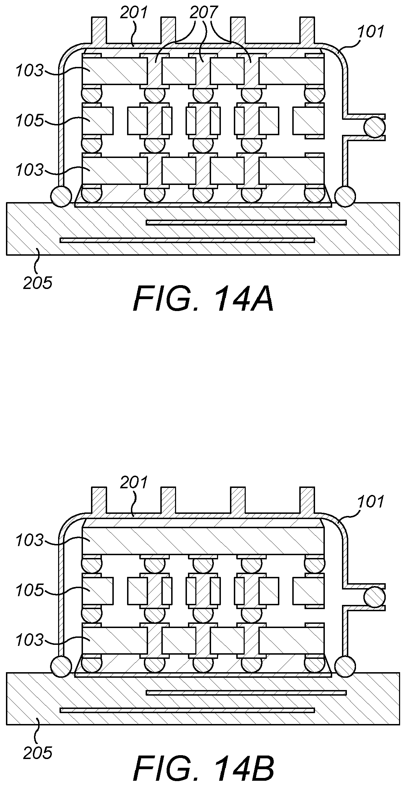

Figs. 14A to 14D show various examples of three-dimensional chips 101. These three-dimensional chips 101 can be formed using the methods of Figs. 8 to 13E and/or any other suitable methods.

In the example of Fig. 14A the three-dimensional chip 101 comprises two integrated circuit layers 103 and a microfluidic layer positioned between the two integrated circuit layers 103. The respective layers 103, 105 are arranged similar to the previously described examples and corresponding reference numerals are used for corresponding features.

In the example of Fig. 14A the top integrated circuit layer 103 comprises a plurality of thermal vias 207. The thermal vias 207 can comprise a conductive material and can extend through the substrate 401 of the integrated circuit layer 103 to the heat rejection surface 201. This can provide for improved heat transfer to the heat rejection surface 201.

In the example of Fig. 14B the three-dimensional chip 101 comprises two integrated circuit layers 103 and a microfluidic layer positioned between the two integrated circuit layers 103. The respective layers 103, 105 are arranged similar to the previously described examples and corresponding reference numerals are used for corresponding features.

In the example of Fig. 14B the top integrated circuit layer 103 does not comprise any thermal vias. One or more electronic components can be provided on the top integrated circuit layer 103.

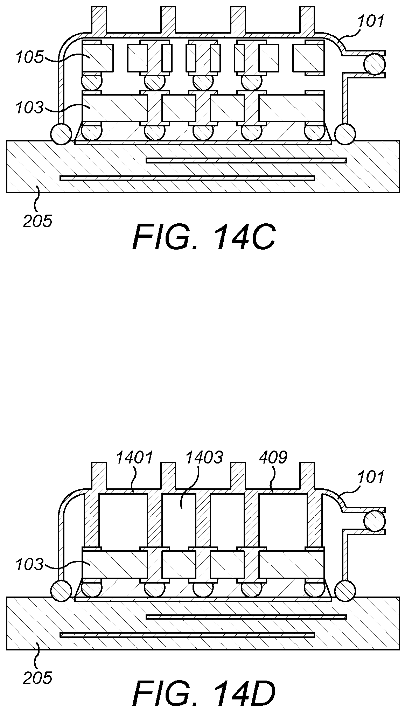

In the example of Fig. 14C the three-dimensional chip 101 comprises only one integrated circuit layer 103 and a microfluidic layer positioned overlaying the integrated circuit layer 103. The respective layers 103, 105 are arranged similar to the previously described examples and corresponding reference numerals are used for corresponding features.

In the example of Fig. 14D only one integrated circuit layer 103 is shown. In this example the encapsulation layer 409 can be configured to provide microfluidic channels 1401 overlaying the integrated circuit layer 103. This can provide heat transfer means for the integrated circuit layer 103. The encapsulation layer 409 and the microfluidic channels 109 within the encapsulation layer 409 can be formed using three-dimensional printing or any other suitable means.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one..." or by using "consisting".

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer any exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. A three-dimensional chip comprising:
a plurality of integrated circuit layers wherein the plurality of integrated circuit layers comprises one or more electronic and/or photonic components and are arranged in a stack;
one or more microfluidic channel layers positioned between integrated circuit layers wherein the microfluidic channel layers comprise microfluidic channels and the microfluidic channels are configured to enable working fluid to flow through the microfluidic channels to provide passive heat transfer means for the one or more electronic and/or photonic components in the integrated circuit layers; and
wherein the microfluidic channels comprise one or more portions that extend along a microfluidic channel layer and one or more portions that extend through a microfluidic channel layer.

2. A three-dimensional chip as claimed in claim 1 wherein the passive heat transfer means comprises a heat pipe.

3. A three-dimensional chip as claimed any preceding claim wherein the passive heat transfer means comprises an oscillating heat pipe.

4. A three-dimensional chip as claimed any preceding claim wherein the passive heat transfer means comprises a two-phase cooling system.

5. A three-dimensional chip as claimed in any preceding claim wherein the microfluidic channel layers comprise one or more vias configured to enable electrical signals to be transferred between integrated circuit layers on either side of the microfluidic channel layer.

6. A three-dimensional chip as claimed in claim 5 wherein the microfluidic channel layers comprise one or more of the vias are also configured to enable working fluid to flow between integrated circuit layers on either side of the microfluidic channel layer.

7. A three-dimensional chip as claimed in any preceding claim comprising a heat rejection surface.

8. A three-dimensional chip as claimed in claim 7 wherein the microfluidic channels are configured to enable heat transfer from the integrated chip layers, though the three-dimensional chip to the heat rejection surface.

9. A three-dimensional chip as claimed in any preceding claim wherein the heat rejection surface is configured to be cooled by an active cooling system.

10. A three-dimensional chip as claimed in any preceding claim comprising means for connecting the three-dimensional chip to a circuit board.

11. A method comprising:
forming two or more integrated circuit layers wherein the integrated circuit layers comprise one or more electronic and/or photonic components;
forming one or more microfluidic channel layers wherein the microfluidic channel layers comprise microfluidic channels are configured to enable working fluid to flow through the microfluidic channels to provide passive heat transfer means for the one or more electronic and/or photonic components in the integrated circuit layers and the microfluidic channels comprise one or more portions that extend along the microfluidic channel layer and one or more portions that extend through the microfluidic channel layer; and
forming a three-dimensional chip by stacking alternating layers of integrated circuit layers and microfluidic channel layers.

12. A method as claimed in claim 11 comprising bonding the alternating layers of integrated circuit layers and microfluidic channel layers together.

13. A method as claimed in any of claims 11 to 12 wherein the microfluidic channel layers are formed by etching microfluidic channels into a substrate.

14. A method as claimed in any of claims 11 to 14 comprising sealing the chip in a metallization layer.
